# DEMANDE DE BREVET EUROPEEN

(11) **EP 0 553 001 A1**
(43) Date de publication de la demande: **28.07.1993**
(21) Numéro de dépôt: 93400064.7
(22) Date de dépôt: 13.01.1993
(51) Int. Cl.: G01R 31/302, G01R 31/26

(54) **Procédé et système de test du fonctionnement et/ou de la présence d'éléments connectés en parallèle**

(30) Priorité: 24.01.1992 FR 9200749
(71) Demandeur: THOMSON-CSF, 75008 Paris (FR)
(72) Inventeur: Cassaigne, Pierre, F-92402 Courbevoie Cédex (FR); Juery, Daniel, F-92402 Courbevoie Cédex (FR)
(74) Mandataire: Benoit, Monique

(57) **Abrégé**

La présente invention concerne un un procédé et un système de test du fonctionnement et/ou de la présence d'éléments connectés en parallèle.

Les composants (3) à tester sont susceptibles d'être dans deux états générateurs d'un rayonnement thermique différent. Pour le cas de diodes testées en direct, ces deux états correspondent à l'état passant et à l'état bloqué.

Le procédé selon l'invention propose d'alimenter l'ensemble avec un signal rectangulaire (2') de fréquence f et d'amplitudes a et b choisies afin de placer cet ensemble dans une succession d'états prédéterminée, choisis à partir des deux états. Le procédé consiste alors à détecter le rayonnement thermique issu de chaque élément, de le transformer en un signal exploitable, puis de vérifier le synchronisme de ce signal avec la fréquence f. Cette vérification permet, suivant le fonctionnement attendu des composants testés, de conclure sur la panne ou le bon fonctionnement d'un composant, et/ou sur sa présence dans l'ensemble.

## Description

La présente invention concerne un procédé et un système de test du fonctionnement et/ou de la présence d'élements connectés en parallèle.

Jusqu'à présent, la mise en évidence d'un ou de plusieurs composants défectueux ou en bon état, ces composants étant placés en parallèle, ne pouvait se faire que par des moyens de mesure globale.

En effet, considérons un ensemble de composants, par exemple de diodes, placés en parallèle. Cet ensemble peut être à l'état bloqué pour lequel aucun courant ne traverse les différents composants, ou , au contraire, à l'état passant. Pour ce qui concerne l'état bloqué, le seul moyen actuel pour savoir si un composant est défectueux est de constater, aux bornes de l'ensemble, une fuite de courant. Dans le cas de l'état passant, les courants qui traversent chaque composant s'ajoutent, de telle sorte qu'il est possible de détecter une panne en comparant le courant global à un courant de référence. Malheureusement, ces deux méthodes globales ne permettent pas de faire une discrimination des composants, c'est-à-dire de connaître précisément le ou les composants qui sont effectivement en panne.

En outre, dans le cas de la fabrication d'un ensemble de diodes, il est impératif d'avoir un générateur de tension stabilisée très précis afin de pouvoir comparer significativement les valeurs de courants directs mesurées à des instants différents, par exemple à chaque ajout d'un composant.

Une technique possible dans certains cas, est de placer des moyens de mesure de courant aux bornes de chaque composant. On imagine aisément les problèmes d'encombrement et de coût de cette technique, lorsque celle-ci est réalisable. Par ailleurs, certains composants, une fois qu'ils ont été connectés lors de la fabrication, ne tolèrent plus aucun contact, et les mesures classiques sont rendues de ce fait impossibles.

Cette dernière contrainte a conduit à utiliser une technique de détection du rayonnement infrarouge issu par exemple des pertes par effet Joule d'un composant alimenté par une source électrique. Le principe de base de cette technique est le suivant : si le composant doit laisser passer du courant en fonctionnement normal, il doit par conséquent avoir des pertes par effet Joule. Ainsi, si aucun rayonnement infrarouge n'est détecté, on peut conclure à la panne de ce composant. Si, au contraire, le composant ne doit laisser passer aucun courant (état bloqué), c'est la détection d'un rayonnement infrarouge qui permettra de déclarer que ce composant est défectueux. C'est sur ce principe que fonctionnent les caméras thermiques qui, associées à un moniteur de visualisation, permettent d'obtenir une image de l'ensemble. Les caméras thermiques actuelles comportent cependant un certain nombre d'inconvénients : dans certaines applications, leur sensibilité est insuffisante pour pouvoir détecter une variation de température dans un composant. De plus, il est nécessaire d'avoir l'ensemble de composants situé très précisément dans le plan focal de la caméra pour obtenir une image de bonne qualité. En outre, les caméras thermiques représentent actuellement un investissement trop élevé.

Une autre méthode connue consiste à mettre une goutte de cristaux liquides sur l'ensemble des composants en parallèle. Si un des composants est anormalement plus chaud que le reste, il apparaît alors un point de transition localisé des cristaux liquides permettant de visualiser le composant défectueux. Cette méthode ne peut être appliquée que pour un ensemble de composants de dimension réduite et présente de plus l'inconvénient d'être polluante pour les composants.

La présente invention a pour objectif de pallier les inconvénients précédents.

Plus précisément, un premier objet de l'invention est un procédé de test du fonctionnement et/ou de la présence d'un ou plusieurs éléments dans un ensemble d'éléments connectés en parallèle, chaque élément ayant sensiblement le même comportement thermique et étant susceptible d'être dans deux états générateurs d'un rayonnement infrarouge différent, le procédé étant caractérisé en ce qu'il consiste à :
- alimenter ledit ensemble avec un signal rectangulaire de fréquence f et d'amplitudes extrémales a et b choisies de façon à placer cet ensemble dans une succession d'états prédéterminée ;
- détecter le rayonnement thermique issu de chaque élément ;
- transformer ledit rayonnement thermique détecté en un signal relatif à chaque élément correspondant ;
- vérifier si la fréquence fₛ dudit signal est synchrone avec ladite fréquence f.
   Un second objet de l'invention est un système mettant en oeuvre le procédé tel que décrit dans les revendications 1 à 6.
   L'invention, ainsi que ses avantages, sera mieux comprise au vu de la description suivante, faite en référence aux figures annexées ;
   - la figure 1 est un exemple d'application du procédé selon l'invention à un ensemble de diodes connectées en parallèle ;
   - la figure 2a représente l'allure du signal qui alimente, selon l'invention, l'ensemble de la figure 1 ;
   - les figures 2b à 2d sont des exemples des signaux observés à la sortie du système selon l'invention appliquée à l'ensemble de la figure 1, ces signaux correspondant respectivement au cas d'une diode qui fonctionne normalement, au cas d'une diode constamment en circuit ouvert et au cas d'une diode en court-circuit ;
   - les figures 3 et 4 illustrent un mode de réalisation possible d'un système selon l'invention.

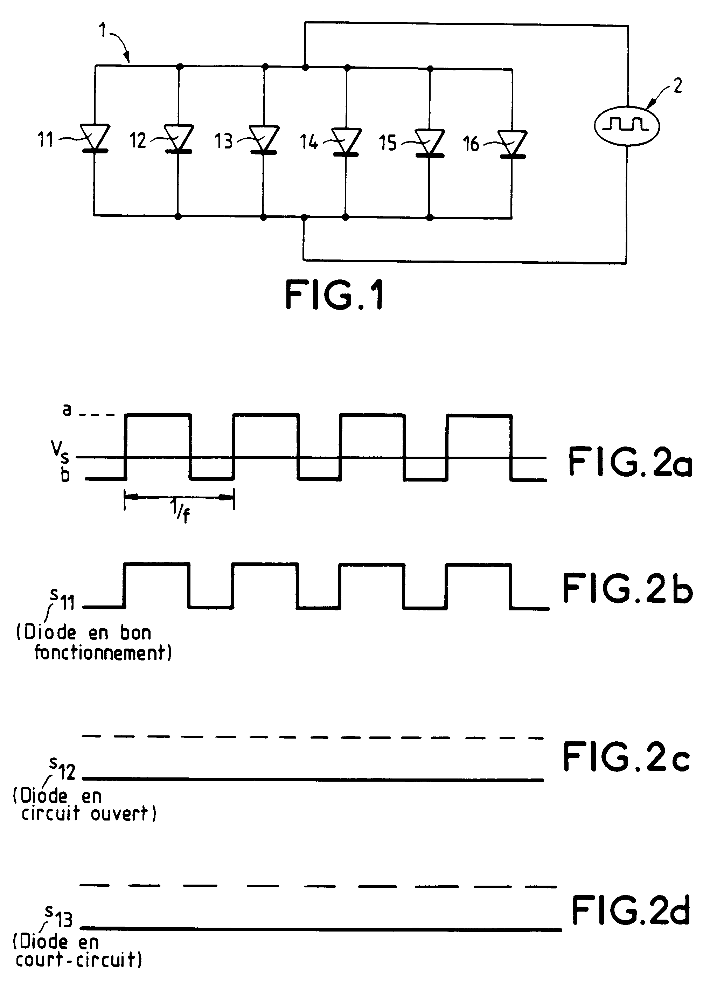

La figure 1 et les figures 2a à 2d illustrent le procédé selon l'invention appliqué à un exemple non limitatif de composants connectés en parallèle :

Sur la figure 1, l'ensemble 1 en question est constitué de six diodes référencées de 11 à 16 et connectées en parallèle. Les diodes 11 à 16 ont une tension de seuil Vₛ et sont susceptibles d'être dans deux états différents lors d'un test en direct, suivant la valeur de la tension appliquée à leurs bornes: un premier état, dit passant, dans lequel chaque diode est traversée par un courant et un second état, dit bloqué, dans lequel aucun courant ne traverse les diodes. Or, selon une condition nécessaire pour l'invention, toute diode utilisée en direct et traversée par un courant, a des pertes par effet Joule, et produit de ce fait un rayonnement thermique, alors qu'une diode à l'état bloqué ne produit aucun rayonnement thermique. Ainsi, suivant le principe de détection du rayonnement infrarouge exposé précédemment, il est possible d'étudier le comportement thermique de chaque diode et d'en déduire son bon ou son mauvais fonctionnement, lors de son utilisation en direct.

Selon une caractéristique essentielle de l'invention, l'ensemble 1 est alimenté par un signal 2 à deux états, rectangulaire ou carré, à la fréquence f, dont l'allure est représentée sur la figure 2a : les deux amplitudes extrémales a et b de ce signal sont choisies de façon à placer l'ensemble 1 dans une succession d'états prédéterminée, en l'occurence successivement dans son premier état (passant) et dans son second état (bloqué).

Dans l'exemple choisi, le signal d'alimentation 2 est une tension, de telle sorte que, pour tester la diode en direct, on a choisi b inférieur à la tension seuil Vₛ des diodes, et a supérieur à cette tension seuil. Bien entendu, l'alimentation peut se faire en courant du moment que le signal d'alimentation possède l'allure de la figure 2 avec les valeurs extrémales a et b qui vont bien.

Par ailleurs, le procédé selon l'invention propose de détecter le rayonnement thermique issu de chaque diode, puis de le transformer en un signal, par exemple électrique, de façon à pouvoir effectivement étudier le comportement des diodes. Supposons à présent que la diode 11 de la figure 1 ne soit pas défectueuse. Le signal électrique s₁₁ possède alors l'allure représentée sur la figure 2b, c'est-à-dire un signal à deux états qui a la même fréquence f que le signal d'alimentation. Dans le cas des figures 2a et 2b, nous avons fait l'hypothèse qu'à un état bas du signal d'alimentation correspondait un état bas du signal s₁₁. Bien entendu, suivant les moyens utilisés en pratique pour détecter le rayonnement thermique et le transformer en signal électrique, la correspondance peut être inversée.

Toujours dans le cadre de l'hypothèse précédente, considérons que la diode 12 de la figure 1 est en panne en ce sens qu'elle se comporte toujours comme un circuit ouvert. Dans ce cas, elle n'est jamais traversée par un courant, et ne rayonne par conséquent pas, ceci, quelle que soit l'amplitude a ou b du signal d'alimentation. Sur la figure 2c, le signal électrique s₁₂ représentatif du rayonnement thermique de la diode 12 est donc constant. Il en va de même pour une diode en court-circuit, par exemple la diode 13, en admettant bien entendu que le court-circuit soit assimilable à un fil électrique faiblement résistif. Ce cas est illustré sur la figure 2d sur laquelle le signal électrique s₁₃ est constant.

Pour détecter et focaliser une panne éventuelle, le procédé selon l'invention propose donc de comparer la fréquence fₛ du signal électrique représentatif du rayonnement thermique de chaque composant avec la fréquence f du signal d'alimentation. Si cette fréquence fₛ est synchrone avec la fréquence f, c'est-à-dire égale, multiple ou sous-multiple de cette fréquence f, on peut conclure, dans le cas de la figure 1, au bon fonctionnement du composant. Dans les autres cas, l'aspect aléatoire du signal traduit une panne du composant.

Bien entendu, dans le cas où les diodes montées en parallèle sont testées en inverse par rapport à celles de la figure 1, il faut inverser également les conclusions précédentes, c'est-à-dire conclure à la panne d'une diode lorsqu'on obtient un signal de fréquence fₛ synchrone de la fréquence f : en effet, en fonctionnement inverse, on peut également, grâce au procédé selon l'invention, tester si chaque diode peut aller jusqu'à sa valeur Vₗ de tension inverse maximale admissible. Il faut prendre alors des amplitudes a et b respectivement inférieure et égale à Vₗ , en valeur absolue, pour que l'apparition d'un signal de fréquence fₛ synchrone avec f traduise un mauvais fonctionnement.

Le procédé selon l'invention tel qu'il vient d'être décrit possède un certain nombre d'avantages par rapport aux techniques de l'art antérieur :

Tout d'abord, la détection du rayonnement thermique d'un composant ne nécessite aucun contact électrique avec ce composant et élimine de ce fait le risque de détérioration dû à une mesure électrique. D'autre part, le procédé selon l'invention permet non seulement de détecter des pannes, mais aussi de connaître précisément le ou les composants qui sont en panne. En outre, l'alimentation par un signal rectangulaire ou carré permet une plus grande souplesse dans la précision du générateur de signal utilisé. En effet, le procédé selon l'invention est fondé sur un changement d'états : on vérifie si la réponse thermique des composants alimentés par le signal suit ce signal, c'est-à-dire est à la même fréquence (ou à une fréquence synchrone).

Le procédé a été décrit dans une application bien particulière concernant un ensemble de diodes montées en parallèle. Bien entendu, il peut s'appliquer à n'importe quels éléments montés en parallèle et susceptibles de produire deux niveaux de rayonnement thermique, et ayant de ce fait deux états possibles. Il peut s'agir par exemple de résistances, ou encore d'un boîtier de plusieurs composants. L'unique contrainte est que tous les éléments montés en parallèle possèdent sensiblement le même comportement thermique lorsqu'ils sont dans l'un quelconque des deux états.

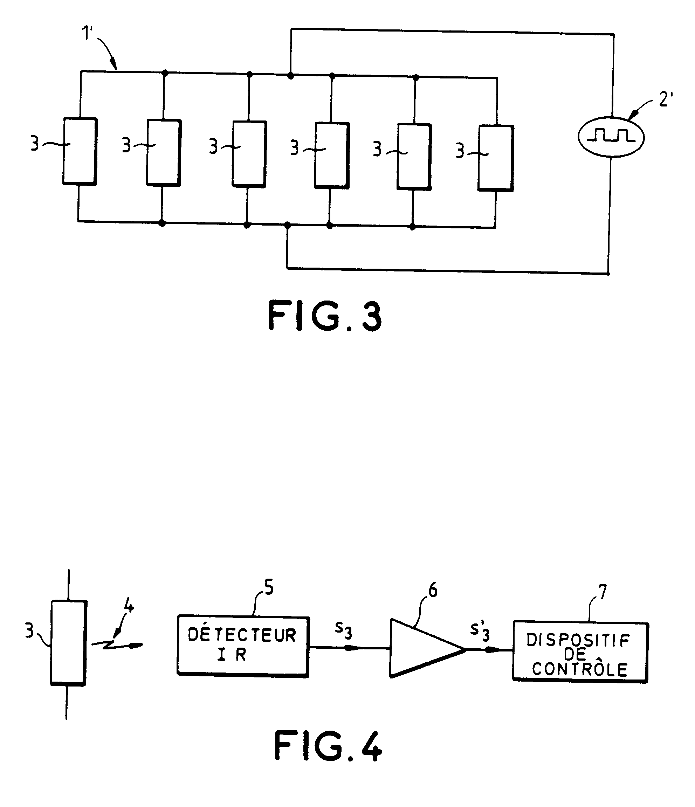

Les figures 3 et 4 montrent une réalisation possible d'un système permettant la mise en oeuvre du procédé selon l'invention :

Sur la figure 3, on a généralisé l'application de l'invention à un ensemble 1' constitué d'une pluralité d'éléments 3 connectés en parallèle et ayant sensiblement le même comportement thermique. Le système selon l'invention comporte des moyens d'alimentation 2' de l'ensemble 1' générant un signal rectangulaire ou carré de fréquence f. Sur la figure 3, ces moyens d'alimentation 2' sont constitués d'un générateur de tension connecté aux bornes de l'ensemble 1'. Il peut s'agir également d'un générateur de courant connecté en série.

Sur la figure 4, on a représenté un élément 3 de l'ensemble 1', susceptible d'émettre un rayonnement thermique 4 lorsqu'il est traversé par un courant. Le système selon l'invention comporte, sur cette figure 4, des moyens 5 pour détecter ce rayonnement thermique et le transformer en un signal électrique s₃. Ces moyens 5 peuvent être constitués d'une thermopile, d'un détecteur pyroélectrique, de diodes photosensibles, ou de tout autre détecteur infrarouge qui est calé sur la bonne longueur d'onde d'émission du rayonnement.

Compte tenu du faible signal électrique s₃ obtenu, on utilise préférentiellement un amplificateur 6 pour obtenir un signal électrique s'₃. Ce signal amplifié s'₃ est alors délivré à un dispositif de contrôle 7 qui permet d'effectuer la comparaison de la fréquence fₛ du signal s'₃ avec la fréquence f du signal d'alimentation. A cet effet, il peut s'agir d'une lampe ou d'une led qui s'allument et s'éteignent à la fréquence du signal s'₃, ou bien d'un vumètre, ou bien encore d'un appareil permettant de délivrer un signal sonore à cette même fréquence. Les exemples précités ne sont évidemment pas limitatifs.

La présente invention trouve son application dans le contrôle des différents éléments d'un ensemble lors des phases de fabrication, c'est-à-dire lors de la connexion de ces éléments ou après ces connexions, ou bien encore, dans le contrôle continu des éléments d'un ensemble lorsque ce dernier fonctionne grâce à un signal rectangulaire. Pour ces applications, il suffit de balayer l'ensemble à contrôler avec le détecteur infrarouge.

## Revendications

1. Procédé de test du fonctionnement et/ou de la présence d'un ou plusieurs éléments dans un ensemble d'éléments connectés en parallèle, chaque élément ayant sensiblement le même comportement thermique et étant susceptible d'être dans deux états générateurs d'un rayonnement infrarouge différent, le procédé étant caractérisé en ce qu'il consiste à :
- alimenter ledit ensemble avec un signal rectangulaire de fréquence f et d'amplitudes extrémales a et b choisies de façon à placer cet ensemble dans une succession d'états prédéterminée ;
- détecter le rayonnement thermique issu de chaque élément ;
- transformer ledit rayonnement thermique détecté en un signal relatif à chaque élément correspondant ;
- vérifier si la fréquence fₛ dudit signal est synchrone avec ladite fréquence f.

2. Procédé de test selon la revendication 1, caractérisé en ce que ladite succession est définie par l'alternance des deux états et en ce que l'obtention d'un signal de fréquence fₛ synchrone avec ladite fréquence f traduit un bon fonctionnement de l'élément correspondant.

3. Procédé de test selon l'une quelconque des revendications 1 ou 2, caractérisé en ce que lesdits éléments sont des diodes de tension de seuil Vₛ, et en ce que lesdites amplitudes extrémales a et b sont choisies de telle sorte qu'elles correspondent à des tensions respectivement supérieure et inférieure à Vₛ afin de placer alternativement chaque diode testée en direct dans un état passant et dans un état bloqué.

4. Procédé de test selon la revendication 1 ou 2, caractérisé en ce que lesdits éléments sont des résistances et en ce que ladite amplitude b est choisie de telle sorte qu'elle corresponde à une tension sensiblement nulle.

5. Procédé de test selon la revendication 1, caractérisé en ce que les états prédéterminés sont constitués par un des deux états, et en ce que l'obtention d'un signal de fréquence fₛ synchrone avec ladite fréquence f traduit un mauvais fonctionnement de l'élément correspondant.

6. Procédé de test selon la revendication 5, caractérisé en ce que lesdits éléments sont des diodes testées en inverse, de tension inverse maximale admissible Vₗ, et en ce que lesdites amplitudes extrémales a et b sont choisies, en valeur absolue, respectivement inférieure et sensiblement égale à ladite tension Vₗ.

7. Système de test du fonctionnement et/ou de la présence d'un ou plusieurs éléments dans un ensemble d'éléments connectés en parallèle, chaque élément ayant sensiblement le même comportement thermique et étant susceptible d'être dans deux états générateurs d'un rayonnement infrarouge différent, le système étant caractérisé en ce qu'il comporte :
- des moyens (2') d'alimentation de l'ensemble (1'), lesdits moyens (2') générant un signal rectangulaire de fréquence f ;
- des moyens (5) qui détectent ledit rayonnement (4) issu de chaque élément (3), et qui transforment ce rayonnement (4) en un signal ;
- un dispositif de contrôle (7) qui vérifie si la fréquence fₛ dudit signal est synchrone avec ladite fréquence f.

8. Système de test selon la revendication 7, caractérisé en ce qu'il comporte en outre un amplificateur 6 pour amplifier ledit signal électrique.

9. Système de test selon l'une quelconque des revendications 7 et 8, caractérisé en ce que les moyens d'alimentation (2') sont constitués par un générateur de tension.

10. Système de test selon l'une quelconque des revendications 7 à 9, caractérisé en ce que lesdits moyens (5) sont constitués par un détecteur infrarouge transformant ledit rayonnement en un signal électrique.

11. Système de test selon l'une quelconque des revendications 7 à 10, caractérisé en ce que lesdits moyens (5) sont constitués par un détecteur infrarouge du type thermopile.

12. Système de test selon l'une quelconque des revendications 7 à 11, caractérisé en ce que le dispositif de contrôle (7) est visuel.

13. Système de test selon la revendication 12, caractérisé en ce que le dispositif de contrôle (7) est une LED.

14. Système de test selon l'une quelconque des revendications 7 à 11, caractérisé en ce que le dispositif de contrôle (7) est sonore.
